# EUROPEAN PATENT APPLICATION

(11) **EP 1 184 799 A1**
(43) Date of publication of application: **06.03.2002**
(21) Application number: 00118676.6
(22) Date of filing: 29.08.2000
(51) Int. Cl.: G06F 17/50

(54) **Providing and using predefined part data for a CAD program**

(71) Applicant: RedSpark, Inc., San Francisco, CA 94107 (US)
(72) Inventor: Mulzer, Matthias, 92224 Amberg (DE)
(74) Representative: Dendorfer, Claus, Dr.

(57) **Abstract**

A method is proposed for providing data (70) defining a predefined part for use in a CAD model processed by a CAD program, said data (70) comprising a plurality of insertion point specifications (86, 88), each insertion point specification (86, 88) defining one possible way of inserting said predefined part into said CAD model with respect to a location and an orientation of a said predefined part for insertion into said CAD model. A method for using such data (70) comprises corresponding features, and a CAD program and an apparatus employ the method for using such data (70). A computer readable data medium is characterized in that is contains such data (70). The invention provides a way of improving the usability of predefined parts for CAD models.

## Description

The present invention concerns the field of computer aided design (CAD) and in particular the field of using predefined part catalogs in connection with CAD techniques.

The use of CAD techniques has become common engineering practice. The available CAD programs range from simple drawing tools to sophisticated systems covering the whole range of product design and possibly further aspects like engineering or manufacturing or quality control. The term "CAD program" as used herein should therefore be understood in its broadest meaning as any computer program that contains a drawing and/or design component and possibly further components, and the term "CAD model" should be understood as any model or document processed by a CAD program. The word "part" is used to designate any object, element or feature that is useful for designing a CAD model. While a part in this sense will normally represent a tangible object like a motor or a ball bearing, it may also be a constructive feature like a groove or a hole.

A present trend in the further development of CAD techniques is the increasing use of predefined part catalogs or libraries. The engineer chooses suitable part definitions for his or her design project and inserts these parts into the CAD model. Such part definitions may come from a variety of sources like the manufacturer of the CAD program or an independent developer or, most importantly, the manufacturer of the actual (physical) parts. Similarly to a good part catalog on paper, the availability of good part definitions in electronic form may greatly increase the manufacturer's revenue since many engineers will then specify these parts in their designs. Therefore many manufacturers invest a considerable amount of time and effort in the development and distribution of electronic part definitions that match their actually sold parts and components.

It is already known to provide predefined part definitions in electronic form for use in CAD models. However, the known techniques are less than perfect. One problem is that, after inserting the predefined part into the CAD model, the designer must in many cases position the part manually with respect to both its position and its orientation. This process requires considerable time and effort and may even lead to design errors or to a lower accuracy of the finished CAD model. The consequence of these difficulties may be that the acceptance of predefined parts is not as high as it could be, especially if the predefined part has a comparatively simple graphical representation that could also be created by the designer "on the fly".

An object of the present invention is therefore to solve the above-mentioned problems at least to some extent. A particular object of the invention is to provide a way of improving the usability of predefined parts for CAD models. Further objects of the invention are to make the process of designing CAD models less costly and to assist the designer in producing high quality CAD models.

The present invention proposes to solve the above-mentioned objects by methods having the features of independent claims 1 and 3 as well as by a CAD program having the features of claim 8, an apparatus having the features of claim 9 and a computer readable data medium having the features of claim 10. The dependent claims define preferred embodiments of the invention. In the terminology used herein, a "data medium" is any entity that may be used for carrying information. This includes tangible media like magnetic and optical computer disks or tapes as well as intangible media like electric or electromagnetic or optical signals.

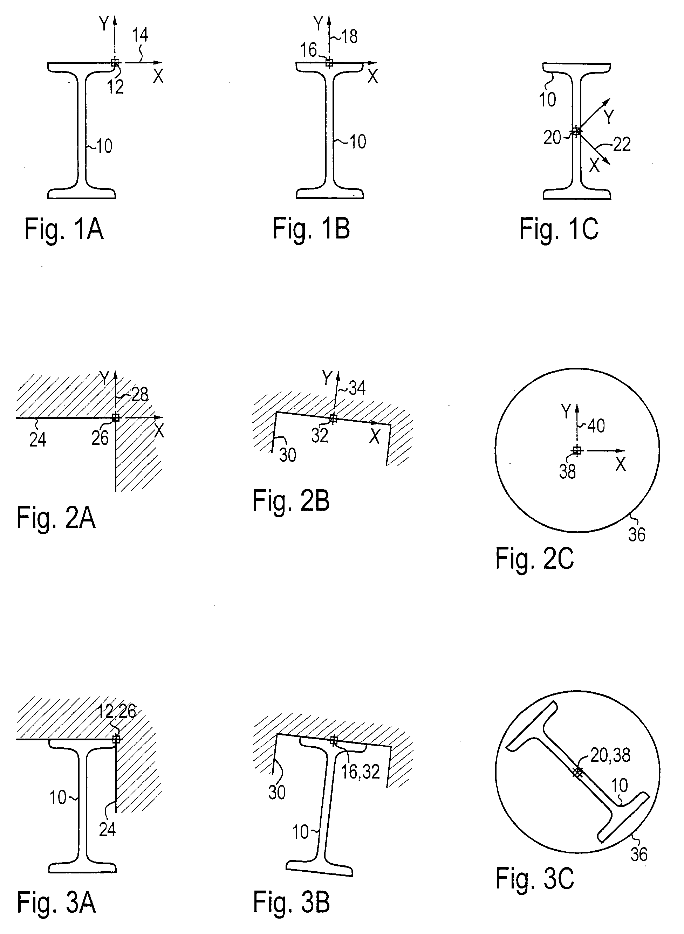

The present invention is based on the idea of providing and using predefined part data that comprises a plurality of insertion point specifications, wherein each insertion point specification defines one possible way of inserting the predefined part into the CAD model with respect to both its location and its orientation. This idea has the considerable advantage that exactly defined insertion points may be used by the designer for a wide variety of designs. The difficulties, errors and inaccuracies associated with manual shifting and/or rotating operations are avoided, and both the quality of the finished CAD model and the efficiency of the design process are improved. The detailed description of the embodiments, especially those shown in Fig. 1A - Fig. 4C, indicates further advantages of the present invention.

In preferred embodiments of the present invention, each insertion point specification of a predefined part comprises a location specification defining a location of an insertion point and an orientation specification defining an insertion coordinate system. When inserting such a predefined part, it is preferred to shift the part such that the location of the insertion point matches a reference point in the CAD model. Furthermore, the predefined part is preferably rotated such that the insertion coordinate system matches a reference coordinate system in the CAD model. This assumes that one insertion point specification of the predefined part has been selected or chosen for the insertion process.

It is further preferred to provide functionality that allows the designer to define and/or change the size of the predefined part when inserting it into the CAD model. The selected insertion point preferably remains a fixed point (e.g., the center point of a linear stretching or compression operation) when the size of the predefined part is defined and/or changed. This feature is especially useful since it allows quick adaption of a predefined part to the actual design requirements. Choosing a suitable insertion point in this case avoids the need for defining extensive auxiliary structures, which would have to be modified whenever the part is resized.

Preferred embodiments of the computer readable data medium, the CAD program and the apparatus of the present invention also comprise features corresponding to the features described above and/or to the features defined in the dependent method claims.

Further features, objects and advantages of the invention will be apparent from the following detailed description of several sample embodiments thereof. Reference is made to the schematic drawings, in which:
Fig. 1A - Fig. 1C show an I beam as an example of a predefined part with three different insertion points,
Fig. 2A - Fig. 2C show three different CAD models into which the I beam of Fig. 1A - Fig. 1C may be inserted,
Fig. 3A - Fig. 3C show the result of inserting the I beam of Fig. 1A - Fig. 1C into the CAD models of Fig. 2A - Fig. 2C, respectively,
Fig. 4A shows a shaft with a ball bearing as a CAD model,
Fig. 4B shows the CAD model of Fig. 4A where a groove has been inserted into the shaft,
Fig. 4C shows an enlarged representation of section C of Fig. 4B,
Fig. 5 shows a sample execution sequence of an embodiment of the present invention,
Fig. 6 shows a sample data structure of a part definition,
Fig. 7A shows a first dialog box used for specifying an insertion point for a 2D part definition, and
Fig. 7B shows a second dialog box used for specifying an insertion point for a 3D part definition.

The predefined part 10 shown, as an example, in Fig. 1A - Fig. 1C is an I beam in a 2D representation and a direction of view along the main axis of the I beam. A first insertion point 12 is depicted in Fig. 1A at the rightmost end of the top face of the I beam. A first insertion coordinate system 14 has its origin at the first insertion point 12 and has an X axis that runs parallel to the top face of the I beam and a Y axis that runs normal thereto.

The first insertion point 12 is the default insertion point of the predefined part 10. However, according to the present invention, the definition of the predefined part 10 comprises further predefined insertion points. Fig. 1B shows the part 10 with a second insertion point 16 positioned in the middle of the top face of the I beam and a second insertion coordinate system 18. Fig. 1C shows a third predefined insertion point 20 positioned in the center of the I beam and a third insertion coordinate system 22, which is oblique to the main faces of the I beam. Any orientation of the insertion coordinate system (e.g., 22) with respect to a main coordinate system of the part 10 can be specified when the definition of the predefined part 10 is created. It is to be noted that Fig. 1A - Fig. 1C show one and the same predefined part 10 comprising (at least) three insertion points 12, 16, 20. For example, the second and third insertion points 16, 20 have not been shown in Fig. 1A for the sake of clarity, but they are nevertheless contained in the definition of the predefined part 10.

The portion of the first CAD model 24 shown in Fig. 2A is an inner corner into which the I beam is to be fitted. The corner point has been designated by the user as a first reference point 26. Fig. 2A further depicts a reference coordinate system 28 that coincides with the global coordinate system of the CAD model 24.

Each insertion operation performed by the CAD program requires the user to specify a reference point (e.g., 26) that will be matched with the applicable insertion point (e.g., 12, 16, 20) of the predefined part (e.g., 10) in a snap-in operation. Furthermore, the predefined part (e.g., 10) will be oriented such that the insertion coordinate system (e.g., 14, 18, 22) coincides with the reference coordinate system (e.g., 28) of the CAD model (e.g., 24). The application of this general rule is shown in Fig. 3A for the example that the predefined part 10 is inserted with its first insertion point 12 into the CAD model 24 with its reference point 26. An exact positioning and orientation of the inserted part 10 is obtained since the first (default) insertion point 12 was by chance suitable for matching with the geometrically well-defined reference point 26.

A second CAD model 30 that poses more difficulties is shown in Fig. 2B. Here the I beam is to be inserted in the middle between two near-vertical walls. If the predefined part 10 had only the single possible insertion point 12 of Fig. 1A, it would be difficult to define a suitable reference point in the CAD model 30. The reference point would have to be displaced from the middle of the structure of Fig. 2B by an amount equal to half the width of the top face of the I beam. Even if the exact dimensions of the I beam are known, it would be a cumbersome operation to define a suitable reference point. This difficulty is even greater in embodiments that allow the user to resize an inserted object "on the fly" since after each resize operation the I beam would have to be moved back to the middle of the structure of Fig. 2B.

The second insertion point 16 (Fig. 1B) of the predefined part 10 greatly increases usability of the part insertion system. The I beam can be inserted exactly in the middle of the structure of Fig. 2B if the second insertion point 16 is used together with a central (second) reference point 32. Defining the central reference point 32 is a straightforward operation using the geometric functions of the CAD program. Fig. 3B depicts the result of the insertion process. No further adjustments by the user are necessary. The predefined part 10 maintains its desired relation to the CAD model 30 even if it is resized by the user. This is because the resizing operation of the presently described embodiment is implemented so that the reference point used for insertion of the part 10 (e.g., central reference point 32) remains a fixed point when the part 10 is resized.

A second reference coordinate system 34 is shown in Fig. 2B. It is apparent from Fig. 3B that, when inserting the predefined part 10 into the second CAD model 30, the orientation of the predefined part 10 is changed (i.e., part 10 is rotated) such that the applicable insertion coordinate system 18 and the reference coordinate system 34 match. As a general rule in the present sample embodiment, the reference coordinate system (e.g., 34) by default coincides with the global coordinate system of the CAD model (e.g., 30). If, however, a reference point (e.g., 32) is located in the scope of some local coordinate system of the CAD model, then the reference coordinate system (e.g., 34) will match the local coordinate system. It is also possible for the user to override these default settings of the present sample embodiment, and to define a customized reference coordinate system (e.g., 34) that best fits his or her design objectives.

A third CAD model 36 with a central (third) reference point 38 and a third reference coordinate system 40 is shown in Fig. 2C. Again, the operation of inserting the I beam of Fig. 1C into the third CAD model 36 yields an accurate result without any subsequent "fine tuning" by the user (see Fig. 3C). It should be noted that any such "fine tuning" would be especially cumbersome in the example of Fig. 3C since the third insertion point 20 is very close to the sides of the web of the I beam. If there was no predefined third insertion point 20, the use of any snap-in functionality for adjusting the I beam would likely lead to an arrangement wherein the reference point 38 is aligned with one of the sides of the I beam instead of its center.

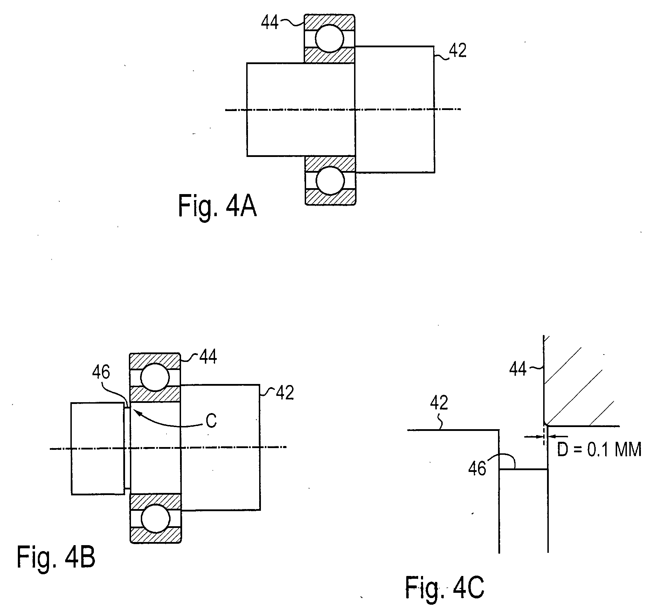

Fig. 4A - Fig. 4C depict an example that would be extremely complex to design without the inventive functionality. Consider a CAD model of a shaft 42 having a shoulder that supports one side of a ball bearing 44 (Fig. 4A). A retaining ring (not shown) is to be used for fixing the ball bearing 44 on the shaft 42. The retaining ring rests in a groove 46 that is to be machined into the shaft 42 (Fig. 4B). This grove 46 is given as a predefined part. The present example therefore also demonstrates that predefined parts do not need to be tangible objects, but can also be holes in some entity of the CAD model or regions or sub-structures of that entity.

It is required from an engineering perspective that the retaining ring rests on the ball bearing 44 instead of the right hand shoulder of the groove 46. For this reason the ball bearing 44 should project over the right hand shoulder of the groove 46 by a small distance. This distance D is shown in Fig. 4C as 0.1 mm. The amount of the distance D is defined by the applicable drafting standard and will be suggested automatically by the CAD program. This avoids the need of looking up the amount of the distance D in a handbook.

It would be difficult and error-prone to position the groove 46 manually with the required accuracy. According to the present invention, this problem is solved by using a predefined part for the groove 46 that has an optional insertion point which is displaced from the shoulder of the groove 46 by 0.1 mm (the default insertion point may be, for example, the center of the groove 46). The groove 46 may then be inserted accurately by using this optional insertion point and a reference point in the CAD model that is defined as the intersection of the horizontal and vertical outer lines of the ball bearing 44 in Fig. 4C.

There are various possibilities for helping the designer choosing a proper insertion point. For example, the definition of the groove 46 may be associated with a definition of the corresponding retaining ring as a predefined part. When the designer selects the retaining ring, a suitable groove 46 and a suitable insertion point on this groove 46 (depending on the size of the retaining ring and on the currently used drafting standards) are automatically suggested. Another possibility would be to interactively ask the designer to indicate the intended use of the groove 46. Depending on the designer's answer, a suitable insertion point (corresponding to the applicable engineering or drafting standards) is proposed. However, even the most basic functionality of presenting the designer a list of possible insertion points with descriptive names represents a substantial improvement over the prior art.

While the above examples have been given for 2D parts and 2D models in order to explain the principles of the present invention more clearly, it as apparent that the same methods and functions can be applied in connection with predefined 3D parts and 3D models. Again, one of a plurality of insertion points defined for each 3D part may be chosen. The predefined 3D part is then inserted in a way that the selected insertion point coincides with the reference point and the insertion coordinate system matches the reference coordinate system. This insertion procedure may involve shifting and/or rotating the predefined 3D part along or about all three axes.

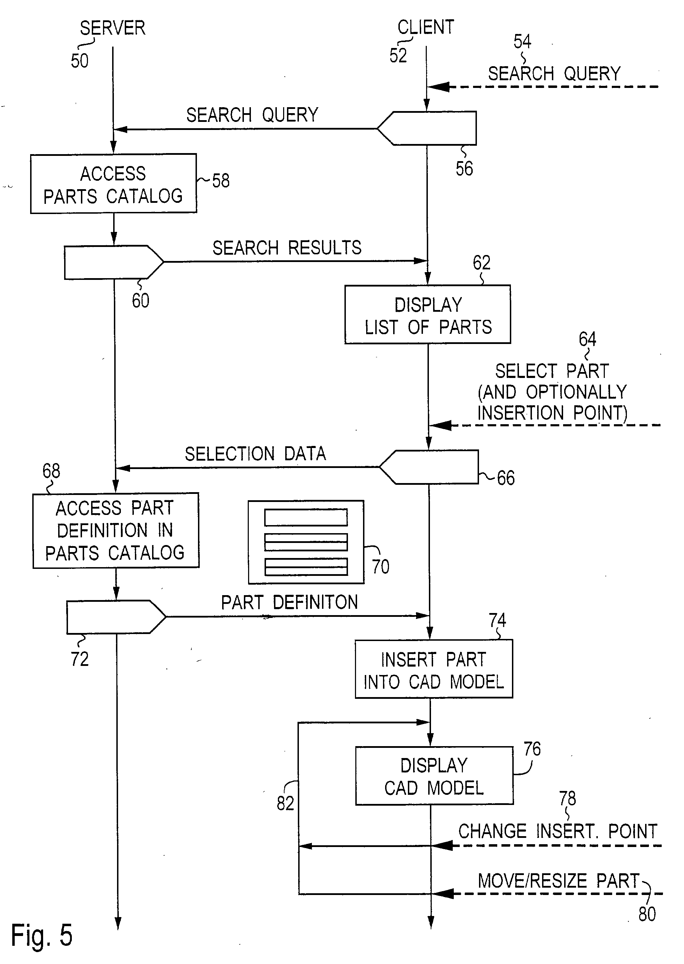

A possible execution sequence of a sample embodiment of the invention is shown in Fig. 5. This execution sequence depicts some of the communication steps between a server 50 and a client 52 and some of the processing steps at the server 50 and the client 52 when the insertion method according to the present sample embodiment is performed. The server 50 is a powerful computer that has access to a database containing a predefined parts catalog. The client 52 is a common personal computer (PC) or a workstation running a CAD program like, for example, the program AutoCAD® manufactured by Autodesk, Inc., USA. The server 50 and the client 52 are connected via a computer network like, for example, the Internet or an intranet.

The process of Fig. 5 starts with the designer requesting a suitable part for his or her CAD model. The designer enters a search query in which the kind of the requested part and optionally also a variety of attributes (e.g., size, material, price range, ...) are specified (step 54). The search query is then forwarded to the server 50 in step 56. The server 50 accesses the parts catalog database and looks for part definitions matching the search query (step 58). The search results, i.e., a list of the parts that have been found in response to the search query, are sent to the client 52 in step 60, and the parts list is displayed to the designer in step 62.

The designer reviews the displayed search results and selects a part from the list in step 64. In the present sample embodiment, each part description of the search result list can be expanded to show the names of all predefined insertion point specifications that are available for this part. It is also possible in some embodiments to show a preview of the selected part with a visible marker for each predefined insertion point. Besides selecting the part in step 64, the designer may also designate the desired insertion point either on the expanded result list or by using the part preview function. If no insertion point is specifically designated by the designer, the default (first) insertion point will be used.

After the designer has made his or her selection, data specifying which part has been chosen is sent to the server 50 in step 66. The server 50 then accesses the full definition 70 of the selected part in the parts catalog (step 68), and sends this part definition 70 to the client 52 in step 72. In the presently described embodiment, the part definition 70 contains all insertion point specifications predefined for the part, whereas in other embodiments only a single insertion point specification corresponding to the insertion point selected by the user in step 64 (or corresponding to the default insertion point) is transmitted. In still other embodiments, the full definitions 70 of all parts matching the designer's search query are transmitted to the client 52 in step 60 as the search result, such that steps 66, 68 and 72 are not needed.

When the part definition 70 has been received by the client 52, the part is inserted into the CAD model as described above in Fig. 1A - Fig. 4C (step 74). This insertion step 74 presupposes that a suitable reference point and a optionally also a reference coordinate system have been defined by the designer either before execution of the method of Fig. 5 or in connection with step 74. The way in which such a reference point and/or coordinate system may be defined using the CAD program is well-known and therefore does not need to be described in detail. After insertion of the predefined part, the updated CAD model is displayed in step 76.

In the presently described sample embodiment, the designer now has the opportunity to change the insertion point (step 78). Preferably a single user action (e.g., pressing the tabulator key) is sufficient for stepping through all available insertion points of the selected part in a cyclic sequence. If necessary, the designer may also move (i.e., shift and/or rotate) or resize the inserted part manually (step 80). Any such interaction of the designer causes the CAD model to be re-displayed (loop 82). An important feature of the present sample embodiment is that the selected insertion point will not move when the part is resized in step 80. In other words, the selected insertion point of a fixed point or reference point under the resizing operation. This feature is very useful for the insertion of combined parts like, for example, a screw connection or a flanged motor.

In some embodiments, the CAD system may also perform an automatic resizing operation to adapt the inserted part to the dimensions of the existing CAD model and/or to given engineering standards. For example, when inserting a screw connection through several layers of material, the dimensions of the connection may be determined automatically from the CAD system's knowledge of the material thickness and the standard screw lengths. Again, the selected insertion point remains fixed under any such resizing operation.

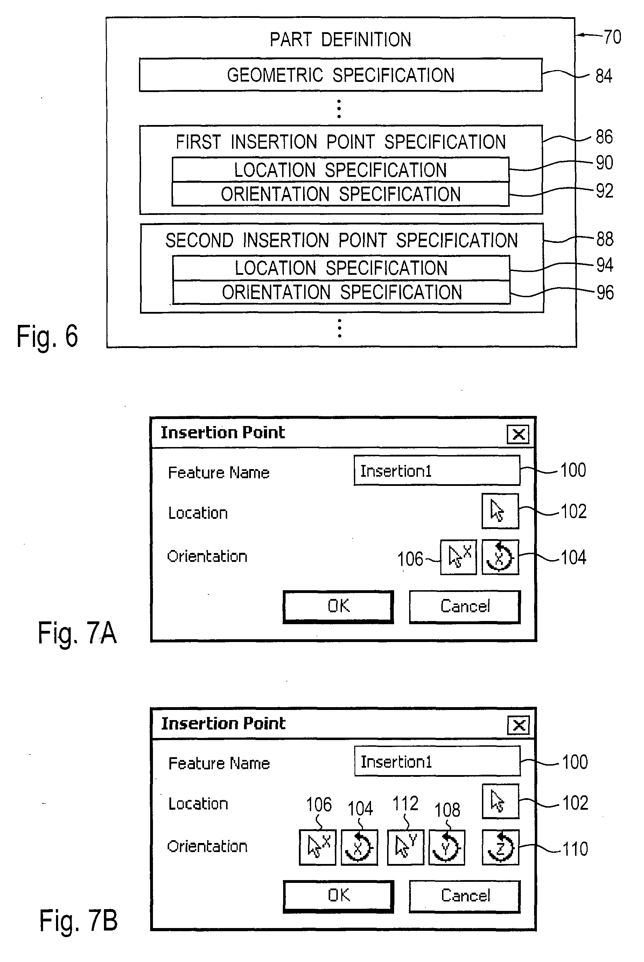

A more detailed view of the data structure that defines one predefined part is given in Fig. 6. The part definition 70 is an encapsulated collection of all data items that are relevant for the designer and/or the manufacturer of the part. A geometric specification 84 of the part comprises the CAD display data that is included in the CAD model during insertion step 74. The part definition 70 further contains several insertion point specifications 86, 88, etc. Each insertion point specification 86, 88, etc. comprises a name of the insertion point as well as a location specification 90, 94, etc. and an orientation specification 92, 96, etc. While only two insertion point specifications 86, 88 are shown in Fig. 6, an arbitrary number of further specifications may be present in the part definition 70.

Each location specification 90, 94, etc. essentially consists of the coordinates of the insertion point (e.g., 12, 16, 20) while each orientation specification 92, 96, etc. essentially consists of data defining the orientation of the insertion coordinate system (e.g., 14, 18, 22). The part definition 70 may contain further data like, for example, search and classification data as well as ordering and price information. This further data, however, is not essential with respect to the present invention and is therefore not described in detail in the present document.

Fig. 7A depicts a possible dialog box that is used for defining insertion points when a part definition 70 for a 2D part is created. A descriptive name of the insertion point may be entered into a text field 100. Button 102 allows the definition of the location of the insertion point. The insertion coordinate system can be defined by rotating the X axis using button 104. As an alternative, button 106 can be used to define the direction of the X axis of the insertion coordinate system as being parallel to a selected line of the predefined part. The new insertion point and the insertion coordinate system are displayed together with the predefined part. The corresponding insertion point specification (e.g., 86, 88) is created and added to the part definition (e.g., 70) when the "OK" button of the dialog box of Fig. 7A is pressed.

A similar dialog box for defining an insertion point of a 3D predefined part is shown in Fig. 7B. Further to the elements already present in the 2D version, the dialog box of Fig. 7B also allows rotation of the Y axis of the insertion coordinate system (button 108) and of its Z axis (button 110). Button 112 serves to align the Y axis with any selected line of the predefined part. A corresponding function could be provided for the Z axis, but tests have shown that this function is used very rarely.

It is apparent that the application possibilities and alternative embodiments described above represent just some examples, and that a wide range of further applications of the teachings of the present invention exist.

## Claims

1. A method of providing data (70) defining a predefined part (10) for use in a CAD model (24, 30, 36) processed by a CAD program, said data (70) comprising a plurality of insertion point specifications (86, 88), each insertion point specification (86, 88) defining one possible way of inserting said predefined part (10) into said CAD model (24, 30, 36) with respect to a location and an orientation of a said predefined part (10) for insertion into said CAD model (24, 30, 36).

2. The method of claim 1, wherein each insertion point specification (86, 88) comprises a location specification (90, 94) defining a location of an insertion point (12, 16, 20) of said predefined part (10) and an orientation specification (92, 96) defining an insertion coordinate system (14, 18, 22) of said predefined part (10).

3. A method of using data (70) defining a predefined part (10) for use in a CAD model (24, 30, 36) processed by a CAD program, said data (70) comprising a plurality of insertion point specifications (86, 88), each insertion point specification (86, 88) defining one possible way of inserting said predefined part (10) into said CAD model (24, 30, 36) with respect to a location and an orientation of a said predefined part (10) for insertion into said CAD model (24, 30, 36).

4. The method of claim 3, wherein each insertion point specification (86, 88) comprises a location specification (90, 94) defining a location of an insertion point (12, 16, 20) of said predefined part (10) and an orientation specification (92, 96) defining an insertion coordinate system (14, 18, 22) of said predefined part (10).

5. The method of claim 3 or claim 4, wherein one insertion point (12, 16, 20) of said plurality of insertion point specifications (86, 88) is selected for inserting said predefined part (10) into said CAD model (24, 30, 36).

6. The method of claim 4 and claim 5, wherein said predefined part (10) is inserted into said CAD model (24, 30, 36) such that the location of said insertion point (12, 16, 20) of the selected insertion point specification (86, 88) matches a reference point (26, 32, 38) in said CAD model (24, 30, 36) and the orientation of said insertion coordinate system (14, 18, 22) of the selected insertion point specification (86, 88) matches a reference coordinate system (28, 34, 40) in said CAD model (24, 30, 36).

7. The method of one of claims 5 to 6, further comprising the step of defining and/or changing the size of the predefined part (10), wherein the selected insertion point (12, 16, 22) remains a fixed point when the size of the predefined part (10) is defined and/or changed.

8. A CAD program adapted for employing the method of one of claims 3 to 7.

9. An apparatus comprising at least one computer, said computer being programmed for performing the steps of the method of one of claims 3 to 7.

10. A computer readable data medium comprising data (70) defining a predefined part (10) for use in a CAD model (24, 30, 36) processed by a CAD program, said data (70) comprising a plurality of insertion point specifications (86, 88), each insertion point specification (86, 88) defining one possible way of inserting said predefined part (10) into said CAD model (24, 30, 36) with respect to a location and an orientation of a said predefined part (10) for insertion into said CAD model (24, 30, 36).

11. The computer readable data medium of claim 10, each insertion point specification (86, 88) comprising a location specification (90, 94) defining a location of an insertion point (12, 16, 20) of said predefined part (10) and an orientation specification (92, 96) defining an insertion coordinate system (14, 18, 22) of said predefined part (10).
